# EUROPÄISCHE PATENTSCHRIFT

(11) **EP 0 656 683 B1**
(45) Veröffentlichungstag und Bekanntmachung des Hinweises auf die Patenterteilung: **06.10.1999**
(21) Anmeldenummer: 94118392.3
(22) Anmeldetag: 23.11.1994
(51) Int. Cl.: H03B 1/04, H03L 7/099

(54) **Anordnung zur Verringerung von Störungen bei Schwingkreisen in integrierten Schaltungen**
Arrangement for the reduction of disturbances in oscillating loops in integrated circuits
Aménagement pour la réduction de parasites dans des circuits oscillateurs dans des circuits intégrés

(30) Priorität: 03.12.1993 DE 4341221
(43) Veröffentlichungstag der Anmeldung: 07.06.1995
(73) Patentinhaber: DEUTSCHE THOMSON-BRANDT GMBH, 78048 Villingen-Schwenningen (DE)
(72) Erfinder: Rieger, Martin, D-78628 Rottweil (DE); Rothermel, Albrecht, D-78048 Villingen-Schwenningen (DE)

(56) Entgegenhaltungen:
- EP-A- 0 347 993
- EP-A- 0 364 035
- EP-A- 0 386 498
- EP-A- 0 416 145
- EP-A- 0 450 750
- WO-A-91/11853
- IEEE TRANSACTIONS ON MICROWAVE THEORY AND TECHNIQUES, Bd.MTT-24, Nr.1, Januar 1976, NEW YORK US Seiten 31 - 39 CORBEY, DAVIES AND GOUGH: 'Wide-Band Varactor-Tuned Coaxial Oscillators'

## Beschreibung

Die Erfindung geht aus von einer Anordnung zur Verringerung von Störungen bei Schwingkreisen in integrierten Schaltungen gemäß dem Oberbegriff des Anspruchs 1.

Es ist bekannt, in integrierten Schaltungen einen Oszillator zu verwenden, der einen Mischer ansteuert. Weiterhin wird dem Mischer über einen äußeren Schwingkreis ein HF-Signal zugeführt, welches durch den Mischer in ein ZF-Signal umgewandelt wird. Bei einer derartigen Anordnung entstehen durch Empfangen und Aussenden von hohen Frequenzen Störungen.

Der Erfindung liegt die Aufgabe zugrunde, eine einfache Anordnung zur Verringerung von Störungen bei Schwingkreisen in integrierten Schaltungen zu schaffen. Diese Aufgabe wird durch die im Anspruch 1 angegebenen Merkmale der Erfindung gelöst. Vorteilhafte Weiterbildungen der Erfindung sind in den Unteransprüchen angegeben.

Bei der bekannten äußeren Beschaltung des Oszillators durch einen Schwingkreis, der vorzugsweise aus einer Induktivität und einem Kondensator besteht, entstehen über die Anschluß-Pins der integrierten Schaltung sowie über den externen Schwingkreis Störungen durch das Empfangen und Aussenden von hohen Frequenzen.

In WO-A-91/11853 wird ein FM-Detektor beschrieben, in welchem die Bauteile auf einem Baustein integriert werden, wobei auf externe Bauteile verzichtet und diese durch interne auf dem Baustein angeordnete Regel- oder Steuerschaltungen ersetzt werden.

Aus EP-A-386 498 ist ein Oszillator bekannt, in welchem die Form und Anordnung jedes Chips und der Verdrahtung dazwischen optimal gewählt wurde. Insbesondere ist daraus bekannt, daß die Bonddrähte möglichst kurz gehalten werden sollen, um Störungen zu vermeiden.

Aus EP-A-364 035 ist ein Zwischenfrequenz-Funkempfänger bekannt, in welchem die induktive Komponente der Filter durch einen oder mehrere Bonddrähte gebildet wird.

Erfindungsgemäß wird der äußere Schwingkreis in die integrierte Schaltung integriert. Die Störungen, welche ansonsten durch die Anschluß-Pins und die Beschaltung entstanden sind, entfallen somit. Ein wesentlicher Grundgedanke dieser Lösung ist damit verbunden, daß die Koppelwirkung des äußeren Anschluß-Pins und deren Beschaltung um ein vielfaches größer ist als die Verbindungspunkte im Inneren der integrierten Schaltung. Durch die Verringerung dieser Koppelwirkung wird gewährleistet, daß ein Einkoppeln von Störungen entfällt.

Der Schwingkreis wird aus einer Induktivität und einer Kapazität gebildet. Die Induktivität wird durch einen Bonddraht in der integrierten Schaltungen gebildet. Die Kapazität wird durch einen Kondensator gebildet. Dieser Kondensator ist zum einen vollkommen wie die anderen Bauteile der integrierten Schaltung im Inneren der Schaltung integriert. Es besteht aber dennoch die Möglichkeit, den Kondensator durch übliche Bauteile zu bilden und ihn auf die integrierte Schaltung aufzukleben.

Da der Schwingkreis abstimmbar gestaltet werden soll, ist vorzugsweise eine Kapazitätsdiode als ein Schwingelement einzusetzen. Da die Induktivität durch Bonddrähte zu bilden ist, werden diese Bonddrähte vorteilhaft dazu herangezogen, die Verbindungsleiter mit dem Kondensator zu bilden.

Ein weiterer Vorteil ist, daß durch den Wegfall der störenden Kapazitäten und Induktivitäten der Anschluß-Pins ein verbesserter Regelbereich des Kondensators vorliegt und der Durchstimmbereich vergrößert wird. Die Kosten werden durch diese Bauweise gesenkt, wobei die komplett integrierende Bauweise der Induktivität und der Kapazität die günstigste Lösung ist.

Der Bonddraht wird reproduzierbar genau gefertigt und in einem Bogen über das Chip den einzelnen Verbindungspunkten zugeführt. Wie die anderen Bonddrähte in der integrierten Schaltung, wird dieser von einer Epoxydharzschicht umgeben, so daß er genau fixiert ist.

Die Zusammenschaltung von mehreren Oszillatoren in einer integrierten Schaltung ist schwer möglich, da sich die Oszillatoren über die Anschlußpins und deren Beschaltung gegenseitig beeinflussen. Auf diese Art und Weise ist es möglich, mehrere Oszillatoren zu verbinden, da der Oszillator in der integrierten Schaltung nicht von dem Oszillator außerhalb der integrierten Schaltung beeinfußt wird.

Bei einer Weiterbildung der Erfindung wird ein Ringoszillator als Oszillator verwendet, um den Mischer mit der entsprechenden Oszillatorfrequenz zu versorgen.

Bei zunehmend höheren Frequenzen tritt das Problem auf, daß die Bonddrähte zunehmend Einfluß auf den Oszillator durch die hohen Frequenzen ausüben. Durch den Einsatz des Ringoszillators, der auch in die integrierte Schaltung integrierbar ist, wird dieser Nachteil beseitigt.

Um das Spektrum des Ringoszillators für die Anwendung entsprechend aufzubauen, ist der Ringoszillator an eine PLL-Schaltung anzubinden. Die PLL-Schaltung regelt Schwankungen bzw. das Phasenrauschen des Ringoszillators aus. Es ist eine PLL-Schaltung mit möglichst großer Bandbreite zu verwenden, da nur innerhalb dieser Bandbreite das Rauschen beseitigt wird, so daß innerhalb dieser Bandbreite die Regelung arbeitet. Die PLL-Schaltung sollte vorzugsweise deshalb eine Bandbreite von 1 MHz aufweisen.

Die Verringerung des Rauschens ist auch möglich, indem schaltungstechnisch der Ringoszillator so gestaltet wird, daß von vornherein kein großes Rauschen auftritt. Das Rauschen würde weiterhin verringert, wenn die als Last dienenden Dioden bzw. mindestens eine Diodenstufe des Ringoszillators, durch einen Schwingkreis ersetzt werden.

Vorteilhaft wäre hierbei die Kombination der breitbandigen PLL-Schaltung und, daß ein besserer Durchstimmbereich und eine lineare Abstimmcharakteristik vorhanden sind.

Die Erfindung wird im folgenden anhand der Zeichnung erläutert. Darin zeigen:
- Fig. 1: eine integrierte Schaltung mit vorgeschalteten Schwingelementen,
- Fig. 2: eine integrierte Schaltung mit integrierten Schwingelementen,
- Fig. 3: einen Ringoszillator und
- Fig. 4: die Kombination Ringoszillator mit einer PLL-Schaltung.

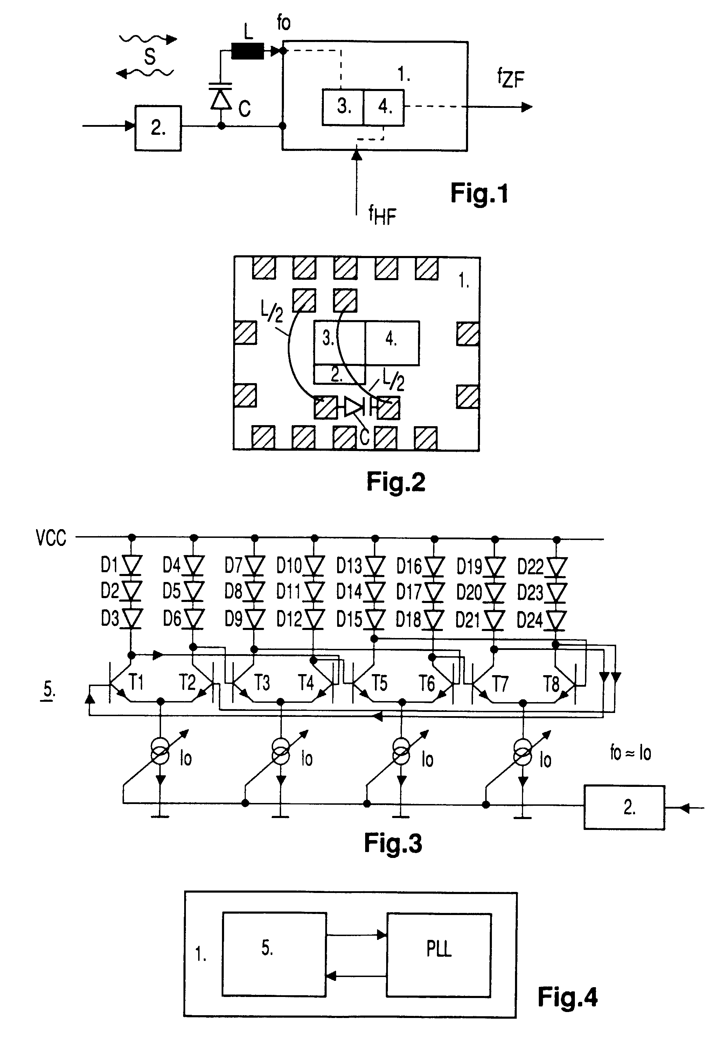

Fig. 1 zeigt eine integrierte Schaltung mit vorgeschalteten Schwingelementen. Der Controller 2 hat Verbindung mit der Kapazitätsdiode C und der integrierten Schaltung 1. Die Kapazitätsdiode C ist über die Induktivität L mit der integrierten Schaltung 1 verbunden. In der integrierten Schaltung befinden sich der Oszillator 3 und der Mischer 4, die in Kontakt miteinander stehen. Die Kapazitätsdiode C und die Induktivität L bilden einen Schwingkreis. Die Frequenz des Schwingkreises fo wird dem Oszillator zugeführt. Die Frequenz fo ist = 1/2 x π √ (L x C). Dem Mischer 4 wird weiterhin die Hochfrequenz fHF = fo ± fHF zugeführt. Die Störungen S beeinflussen den vorgegebenen Schwingkreis in negativer Weise.

Fig. 2 zeigt eine integrierte Schaltung mit integrierten Schwingelementen. Der Controller 2, der Oszillator 3, der Mischer 4, die Kapazitätsdiode C und die Induktivität L sind in die integrierte Schaltung integriert. Die Induktivität L wird jeweils durch einen Bonddraht gebildet. Die Gesamtinduktivität L ergibt sich jeweils durch die Addition der Teilinduktivitäten der beiden Bonddrähte. Die Bonddrähte sind bogenförmig angeordnet. Die Kapazitätsdiode ist in diesem Fall auf die integrierte Schaltung aufgeklebt. Die Bonddrähte dienen also vorzugsweise auch noch als Verbindungsleiter.

Fig. 3 zeigt einen bekannten Ringoszillator. Die Spannung VCC wird den Dioden D1, D4, D7, D10, D13, D16, D19, D22 zugeführt. Jeweils 3 Dioden D1, D2, D3; D4, D5, D6; D7, D8, D9; D10, D11, D12; D13, D14, D15; D16, D17, D18; D19, D20, D21; D22, D23, D24 sind in Reihe geschaltet und liegen vor den Kollektoren der Transistoren T1, T2, T3, T4, T5, T6, T7, T8. Der Kollektor des Transistors T1 ist auf die Basis des Transistors T4 geschaltet. Der Kollektor des Transistors T2 ist auf die Basis des Transistors T3 geschaltet. Der Kollektor des Transistors T3 ist auf die Basis des Transistors T6 geschaltet. Der Kollektor des Transistors T4 ist auf die Basis des Transistors T5 geschaltet. Der Kollektor des Transistors T5 ist auf die Basis des Transistors T8 gechaltet. Der Kollektor des Transistors T6 ist auf die Basis des Transistors T7 geschaltet. Der Kollektor des Transistors T7 ist auf die Basis des Transistors T1 geschaltet. Der Kollektor des Transistors T8 ist auf die Basis des Transistors T2 geschaltet. Die Emitter der Transistoren T1, T2; T3, T4; T5, T6; T7, T8 sind miteinander verbunden und der Stromquelle I₀ zugeführt. Die Stromquelle I₀ ist durch den Controller 2 regelbar. Die Frequenz fo ist proportional der Stromquelle I₀.

Fig. 4 zeigt die Kombination Ringoszillator 5 mit einer PLL-Schaltung. Diese Kombination ist in einer integrierten Schaltung 1 zusammengefaßt. Bei einer testmäßigen Zusammenschaltung eines Ringoszillators und einer PLL-Schaltung sind Abstimmbereiche von 30 MHz bis bis 2 GHz mit einer derartigen Anordnung möglich. Weiterhin ist die Abstimmung sehr linear, d. h. in Abhängigkeit von den Parametern ändert sich die Frequenz linear. In diesem Fall ändert sich also der Strom linear in Abhängigkeit von der Frequenz.

## Patentansprüche

1. Anordnung mit störungsverringernder Wirkung bei einer integrierten Schaltung mit einem Controller (2), mit einem Oszillator (3), mit einem Mischer (4), mit einer Kapazitätsdiode (C), mit einer Induktivität (L), **dadurch gekennzeichnet, daß**
der Controller (2) über einen ersten Bonddraht, der eine erste Induktivität bildet, mit der Kapazitätsdiode (C) verbunden ist und
daß die Kapazitätsdiode (C) über einen zweiten Bonddraht, der eine zweite Induktivität bildet, mit dem Oszillator (3) verbunden ist und
daß der Oszillator mit dem Mischer verbunden ist.

2. Anordnung nach Anspruch 1, **dadurch gekennzeichnet, daß** der erste Bonddraht und der zweite Bonddraht die Gesamtinduktivität bilden.

3. Anordnung nach Anspruch 1, **dadurch gekennzeichnet, daß** der ersten Teil der Induktivität und der zweiten Teil der Induktivität jeweils die Hälfte der Gesamtinduktivität bilden.

4. Anordnung nach Anspruch 3, **dadurch gekennzeichnet, daß** die Bonddrähte bogenförmig angeordnet und in einer Epoxydharzschicht eingegossen sind.

5. Anordnung nach Anspruch 3, **dadurch gekennzeichnet, daß** die Kapazitätsdiode (C) auf die integrierte Schaltung aufgeklebt ist.

## Claims

1. Arrangement with interference reducing operation at an integrated circuit including a controller (2), an oscillator (3), a mixer (4), a capacitance diode (C) and an inductivity (L)
characterized in that
the controller (2) is connected via a first bonding wire forming a first inductivity to the capacitance diode (C) and
that the capacitance diode (C) is connected to the oscillator (3) via a second bonding wire forming a second inductivity and
that the oscillator is connected to the mixer.

2. Arrangement according to claim 1, characterized in that the first bonding wire and the second bonding wire form the total inductivity.

3. Arrangement according to claim 1, characterized in that the first part of the inductivity and the second part of the inductivity each form half the total inductivity.

4. Arrangement according to claim 3, characterized in that the bonding wires are arranged in the form of an arc and are potted in an epoxy-resin layer.

5. Arrangement according to Claim 3, characterized in that the capacitance diode (C) is bonded on the integrated circuit.

## Revendications

1. Aménagement avec action de réduction des parasites dans le cas d'un circuit intégré comprenant un contrôleur (2), un oscillateur (3), un mélangeur (4), une diode de capacité (C), une inductance (L), **caractérisé en ce que**
le contrôleur (2) est relié à la diode de capacité (C), sur un premier fil de liaison qui établit une première inductance et
la diode de capacité (C) est reliée à l'oscillateur (3), sur un deuxième fil de liaison qui établit une deuxième inductance et
l'oscillateur est relié au mélangeur.

2. Aménagement conforme à la revendication 1, **caractérisé en ce que** le premier fil de liaison et le deuxième fil de liaison établissent l'inductance totale.

3. Aménagement conforme à la revendication 1, **caractérisé en ce que** la première partie de l'inductance et la deuxième partie de l'inductance établissent chacune la moitié de l'inductance totale.

4. Aménagement conforme à la revendication 3, **caractérisé en ce que** les fils de liaison sont placés en coude et recouverts d'une couche de résine époxy.

5. Aménagement conforme à la revendication 3, **caractérisé en ce que** la diode de capacité (C) est collée au circuit intégré.
